# EUROPEAN PATENT APPLICATION

(11) **EP 4 797 323 A1**
(43) Date of publication of application: **26.08.2026**
(21) Application number: 25170490.4
(22) Date of filing: 14.04.2025
(51) Int. Cl.: H01L 21/67, H01L 21/673

(54) **METHODS AND SYSTEMS FOR MEASURING CONTAMINATION OF SEMICONDUCTOR CARRIER DEVICES**

(30) Priority: 19.02.2025 EP 25158912
(71) Applicant: Brooks Automation (Germany) GmbH, 78256 Steißlingen (DE)
(72) Inventor: Balak, Scott, Lunenburg, MA, 01462 (US); Dewsnap, Iain, Manchester, M20 2QJ (GB); Grayfer, Anatoly, Sharon, MA, 02067 (US); Li, Fan, 78267 Aach (DE)
(74) Representative: Dehns Germany Partnerschaft mbB

(57) **Abstract**

Provided is a method for measuring a contamination of a semiconductor carrier device (150), using a measuring device (120) connected to a load port (101) for the semiconductor carrier device, the method comprising: after the semiconductor carrier device has arrived in or at the load port: establishing a fluid connection of the measuring device, to an inside of the semiconductor carrier device and measuring the contamination of the semiconductor carrier device; and Providing a measurement result (122). Provided is also a corresponding system (100).

## Description

The present invention relates to methods and systems for measuring contamination of semiconductor carrier devices such as FOUPs.

### Background

Semiconductor carrier devices such as FOUPs (Front Opening Unified Pods) are important in connection with wafer transport and contamination control within and outside of semiconductor fabrication plants, also known as fabs. The environment within the FOUP, the FOUP mini-environment, is responsible for isolating the wafers from the fab environment and at the same time transporting the wafers safely between tools and within the fab.

Performance of integrated circuit devices and overall yield are negatively impacted by AMCs (Airborne Molecular Contaminations). A detrimental effect on semiconductors substrates (wafers) is caused by condensable organics, inorganic acids and bases, siloxanes and etc. Typical FOUP cleaning equipment is capable to remove or reduce AMCs utilizing, e.g., hot jetted water treatment or hot CDA drying and additional vacuum de-gassing.

However, it has turned out that depending on exposure dose (i.e., concentration multiplied by time), residual contaminations may still exist since mini-environments (ME) comprise an enclosed shelter made of intrinsically porous polymeric materials capable to absorb and/or retain and outgas AMCs which originate from process chemicals, wafer processing steps and fab environment.

In the present disclosure, new approaches are suggested to deal with this problem. The same approaches could be used for cleaning other semiconductor carrier devices, such as, reticle pods, especially EUV pods.

### Summary

The present invention addresses these problems by providing methods and systems for measuring contamination of semiconductor carrier devices. Advantageous embodiments and additional features are provided in the dependent claims and further discussed in the following description.

There is provided a method for measuring a contamination like AMC of a semiconductor carrier device, using a measuring device connected to a load port for the semiconductor carrier device. The method comprises, after the semiconductor carrier device has arrived in or at the load port: establishing a fluid connection of the measuring device, to an inside of the semiconductor carrier device and measuring the contamination of the semiconductor carrier device. The method further comprises providing a measurement result.

Using such a measuring device connected to a load port for the semiconductor carrier device allows a compact system. In an embodiment, the measuring device can be integrated into a semiconductor carrier device handling apparatus which comprises the load port. The semiconductor carrier device handling apparatus can be, for example, an optical inspection station or an overhead transportation station. This allows a high level of customization and cost reduction. In combination with optical inspection, for example, such proposed AMC inspection system will provide a total solution, i.e. cleaning and total inspection within one tool.

In an embodiment, based on the measurement result, a customized cleaning recipe for the semiconductor carrier device is determined. The specific measurement allows to tailor the subsequent cleaning procedure to be only as much as necessary. This helps reducing resources, costs and time.

For example, if the measurement result indicates a contamination of the semiconductor carrier device is below a pre-defined threshold, the customized cleaning recipe comprises a light cleaning recipe, and if the measurement result indicates a contamination of the semiconductor carrier device is above the pre-defined threshold, the customized cleaning recipe comprises a hard cleaning recipe. The hard cleaning recipe comprises at least one of the following parameters with respect to or compared to the light cleaning recipe: a longer cleaning time, a higher temperature of dry gas, a higher water pressure, using de-gassing step, using IR-lamp. It is noted that also more than two different cleaning recipes can be provided. The pre-defined threshold can be defined for one or more of different contamination agents.

In an embodiment, the method further comprises, before the semiconductor carrier device has arrived in or at the load port, cleaning the measuring device. This can comprise purging the measuring device with ultra-pure gases to ensure a low background and readiness to conduct the actual measurements.

In an embodiment, the method further comprises heating the semiconductor carrier device, at least partly during measuring the contamination of the semiconductor carrier device. Then, based on the measurement result, a contamination level of the semiconductor carrier device that will be reached is determined. For heating, a furnace in which the semiconductor carrier device or at least a part of it is placed can be used, for example. The contamination level depends on the exposure dose (i.e., concentration multiplied by time) and such level is difficult to predict and control, in particular in high volume semiconductor carrier devices. Sometimes, multiple cleaning cycles are required to achieve a set contamination level; and sometimes, there is outgassing post-cleaning, reaching a higher level only after several hours.

It has now turned out that heating the semiconductor carrier device results in an accelerated outgassing. Thus, the contamination level that will be reached can be determined faster, i.e., an additional cleaning cycle can, for example, be done sooner than without the heating. Without that heating, the time until it can be determined whether or not an additional cleaning cycle is required would be much longer, e.g., 24 hours instead of 5 or 10 hours.

In an embodiment, a vacuum chamber associated with the load port is used, wherein the semiconductor carrier device is to be placed in the vacuum chamber. While the inside of the semiconductor carrier device can be analysed (even with evacuation) without an additional vacuum chamber, such vacuum chamber allows an even better measurement result. Note that evacuation of the vacuum chamber and/or the inside of the semiconductor carrier device does not require full evacuation; typically, a remaining pressure of 10 to 50 Pa, e.g., 15 Pa, is sufficient.

For example, this allows that the semiconductor carrier device is heated by means of one or multiple IR lamps arranged inside the vacuum chamber. Multiple IR (i.e., infrared) lamps can be distributed equally around the semiconductor carrier device or its outer shell. This allows uniform heating for the accelerated degassing.

In an embodiment, an inside of the semiconductor carrier device is confined in that the semiconductor carrier device is moved towards a docking plate of the vacuum chamber by means of a moving system arranged at least partly inside the vacuum chamber. A lid of the semiconductor carrier device would have to be remove beforehand. This allows efficiently establishing evacuation and contamination measurement of the semiconductor carrier device, e.g., via respective feedthroughs.

In an embodiment, the method further comprises providing a spraying system comprising one or multiple nozzles inside the semiconductor carrier device, and spraying gas via the one or multiple nozzles onto one or multiple walls of the semiconductor carrier device for dislocation contamination for the measuring. FOUPs are typically made of porous materials, for example polycarbonate materials. Contamination molecules, especially in the form of AMC, enter these pores, and it requires energy in order for them to be able to diffuse out of the pores again. This force can be especially enhanced and/or directed or focussed onto an area of interest by providing the gas (preferably warm gas) via nozzles directed at the semiconductor device in a desired angle. It is also possible to vary the angle of the nozzles in relation to the semiconductor carrier device.

In an embodiment, the method further comprises, before measuring the contamination of the semiconductor carrier device, optically inspecting an inside of the semiconductor carrier device, by means of a camera arranged inside the vacuum chamber. This may require rotating the semiconductor carrier device, e.g., by 180°, such as to turn the opening of the semiconductor carrier device from the camera to the docking plate. This allows integrating an optical inspection and the contamination measurement into one system, what increases overall efficiency, and reduces costs and time.

In an embodiment, the measuring device is integrated into a semiconductor or wafer sorting apparatus, which apparatus comprises the load port. The contamination of the semiconductor carrier device is measured for at least one of the following situations: A loaded situation, with the semiconductor or wafer having been processed and being placed in the semiconductor carrier device; and an unloaded situation, with the semiconductor or wafer having been removed from the semiconductor carrier device.

For example, for the loaded situation, if the measurement result indicates a contamination of the semiconductor carrier device is above a first pre-defined threshold, a diagnostic measurement is performed. For the unloaded situation, if the measurement result indicates a contamination of the semiconductor carrier device is above a second pre-defined threshold, a diagnostic measurement is performed. The diagnostic measurement can be the same in both case whereas the first and second pre-defined threshold can (but do not need to) differ from each other. In addition, based on a result of the diagnostic measurement, a cleaning recipe for the semiconductor carrier device may be determined for subsequent cleaning.

Such integration of the contamination measurement in the sorting process provides a fast and efficient way to sort out semiconductor carrier device that are too dirty at an early stage. For the loaded situation, also the wafer can, for example, not at all be unloaded the usual way and thus prevent any unwanted further contamination. For the unloaded situation, the semiconductor carrier device will not be used further in the usual way. In both cases, the diagnostic measurement allows further insight and, if required, to reject the semiconductor carrier device from immediate further use but subject it to special cleaning or another action, for example.

In an embodiment, the contamination is AMC and the measuring device is an AMC metrology. For example, the measuring device can be configured to detect and/or measure contamination level of one or more pre-defined AMC types or components, e.g., ammonia, total bases, acids, organics, residual humidity. For example, the measuring device can be based on at least one of: ion-mobility spectrometry, cavity ring down spectroscopy, UV fluorescence, proton transfer reaction - quad mass spectrometry, flame ionization detection. These types of contaminations to be detected and measured as well as these kinds of measuring device allow covering the most relevant contamination

The methods according to the invention and in the various embodiments can also advantageously be used for cleaning other semiconductor carrier devices, such as reticle pods, especially EUV reticle pods.

There is also provided a corresponding system for measuring a contamination like AMC of a semiconductor carrier device, the system comprising a load port for the semiconductor carrier device and a measuring device connected to the load port. The system is configured to, after the semiconductor carrier device has arrived in or at the load port, establish a fluid connection of the measuring device, to an inside of the semiconductor carrier device and measuring the contamination of the semiconductor carrier device. The system is also configured to provide a measurement result. The system can comprise a computing device incorporating one or more processors, for example, which allows evaluation to obtain the measurement results.

For further embodiments and advantages of the system it is referred to the description of the method and respective embodiments, which applies accordingly. In particular, the system implements the method according to any one of the mentioned embodiments. This may require the system comprising one or more additional components mentioned in the respective embodiment.

### Drawings

- Fig. 1: schematically shows a system for measuring a contamination of a semiconductor carrier device in an embodiment;
- Fig. 2: schematically shows a diagram for explanation of an aspect of the invention;
- Fig. 3: schematically shows a diagram for explanation of an aspect of the invention;
- Fig. 4: schematically shows a diagram for explanation of an aspect of the invention;
- Fig. 5: schematically shows a diagram for explanation of an aspect of the invention;
- Fig. 6: schematically shows a diagram for explanation of another embodiment for measuring a contamination of a semiconductor carrier device;
- Fig. 7: schematically shows a system for measuring a contamination of a semiconductor carrier device in the embodiment according to Fig. 6;
- Fig. 8: schematically shows a diagram for explanation of an aspect of the invention;
- Fig. 9: schematically shows a flow diagram for explanation of another embodiment for measuring a contamination of a semiconductor carrier device;
- Fig. 10: schematically shows a flow diagram for additional steps of the embodiment according to Fig. 9;
- Fig. 11: shows a system for measuring a contamination of a semiconductor carrier device in another embodiment
- Fig. 12: schematically shows a system for measuring a contamination of a semiconductor carrier device in the embodiment according to Fig. 11;
- Fig. 13: shows a system for measuring a contamination of a semiconductor carrier device in another embodiment; and
- Fig. 14: shows a system for measuring a contamination of a semiconductor carrier device in the embodiment according to Fig. 13.

### Description of the drawings

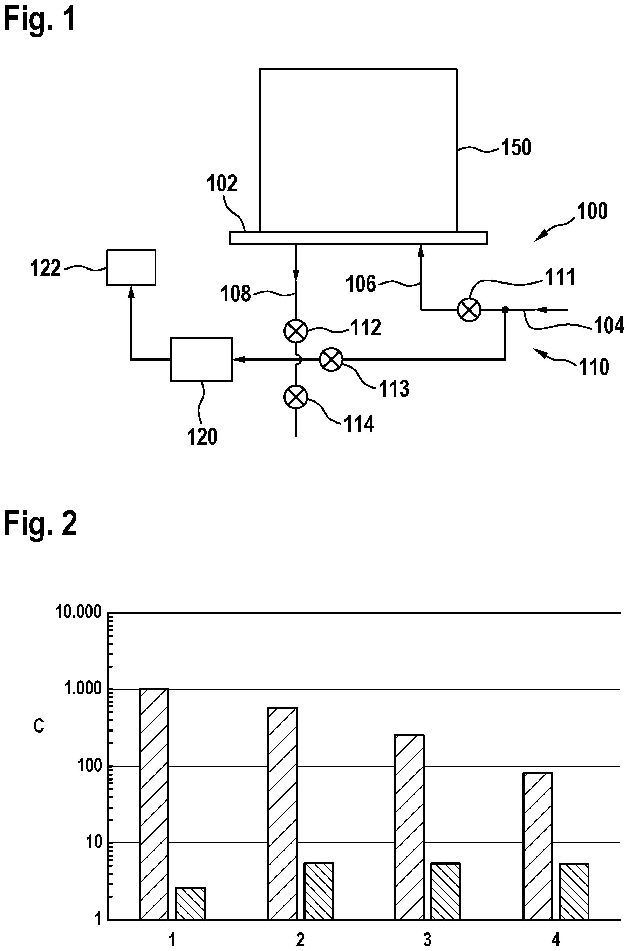

Fig. 1 illustrates a system 100 for measuring a contamination of a semiconductor carrier device 150, e.g. a FOUP, in an embodiment. This embodiment relates to the integration of contamination measuring of a semiconductor carrier device, in particular AMC metrology systems and methods into front opening unified pods (FOUPs) handling equipment such as FOUP cleaning and wafer sorter. Integrated AMC metrology or other contamination measurement system can help to reduce metrology cost for high volume semiconductor devices manufacturing and rapidly react on occurrence of contamination events.

Note that in the following AMC as a typical and important example of contamination of a FOUP as a semiconductor carrier device is described in more detail. This, however, can also be used for other types of contamination and other types of semiconductor carrier devices as mentioned above.

Integrated circuit device performance and overall yield are negatively impacted by AMCs. Detrimental effect on semiconductors substrates is caused by condensable organics, inorganic acids and bases, siloxanes and etc. FOUP cleaning equipment is capable to remove or at least reduce AMCs utilizing, e.g. hot jetted water treatment and/or hot CDA drying and/or additional vacuum de-gassing. However, depending on the exposure dose (concentration times time) residual contaminations may still exist since mini-environments (ME) like the FOUP comprise an enclosed shelter made of intrinsically porous polymeric materials capable to absorb and/or retain and outgas AMCs which can originate from process chemicals, wafer processing steps and fab environment.

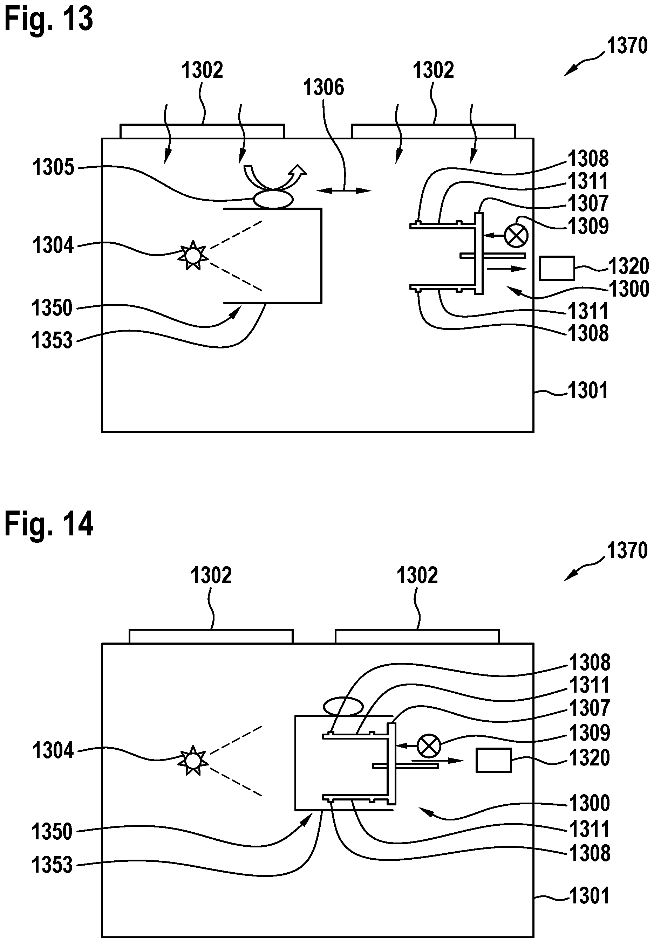

There are several locations within FOUP's cleaning equipment where AMC metrology can be deployed. For instance, an apparatuses' (e.g., the Brooks M800 Automated FOUP Cleaner) front end may consist of or may comprise an optical inspection station (IS) for incoming FOUP evaluation to determine presence of foreign objects, gasket misalignment, missing or misplaced parts inside, condition of purge ports and FOUP gas conductance indicating likelihood of a leaks. The inspection station (IS) with necessary computer-driven hardware may utilize a load port on which the FOUP is placed and a gas sample is drawn from the mini-environment and transferred to the AMC detection device capable for detect at least one gaseous specie of concern (a type of contamination). An example of an optical inspection station, i.e. an apparatus for optically inspecting an inside of the semiconductor carrier device, is shown in Figs. 13 and 14 and described with reference thereto.

Yet, another place for metrology insertion is, for example, an OHT (overhead transportation) load port where FOUPs can be inspected for leaks and simultaneously for AMCs before cleaning or after cleaning.

An addition of AMC metrology integrated into to the FOUPs cleaning process is highly beneficial and enables the application of custom cleaning recipes (so-called "smart recipes") to reduce wafer contamination events and also cost of ownership via flexible variation of tool cleaning resources.

In an example or scenario, a FOUP is inspected and a low level of ionic AMCs (e.g. acids and bases) is measured. This event will trigger the selection of a "light clean" recipe with reduced cleaning time, reduced temperature of drying gas, reduced water pressure (for the case when integrated in-line water heaters are used) and vacuum degassing can be skipped (parameters). In this scenario tool utilization (i.e. utilization of the cleaning tools) will be high (high throughput) and consumption of cleaning resources will be low.

In another example or scenario, a FOUP is inspected and a high level of AMCs (e.g., VOCs, Volatile organic compounds) is measured. This event will trigger the application of a "hard clean" recipe with extended clean time, increased temperature of drying gas, extended vacuum degassing with high utilization of one or multiple IR lamps (parameters). In this case the tool throughput will be lower and the utilization of cleaning resources will be higher.

Note that these two recipes are only examples and other recipes can be used. For example, a recipe can include only one or several selected ones of the mentioned parameters or other parameters.

It is conceivable that different FOUP lots can be mixed together to keep the throughput high. Also, highly contaminated FOUPs can be treated separately in special runs.

The AMC analytical device (measuring device) may include one or more blocks (e.g. measuring and/or analysing units) for detection and/or quantification of specific contaminants such as ammonia (or total bases), acids, organics and residual humidity. The specific measuring device can include one or more tools from a wide array of tools available, such as IMS (ion-mobility spectrometry), CRDS (cavity ring down spectroscopy), UV fluorescence, PTR-QMS (proton transfer reaction - quad mass spectrometry), FID (flame ionization detection) or other real-time, high-sensitive detection techniques allowing speciation of contaminations or detection without speciation.

The system 100 illustrated in Fig. 1 is a general schematic view and presents a general design of a proposed system and its operation for real-time detection of AMCs (Airborne Molecular Contaminations) in a FOUP 150 (as an example of a semiconductor carrier device) when it is placed on a load port 102 (LP) enabled with a valving system 110 to conduct such measurements. The valving system 110 comprises, by means of example, valves 111, 112, 113, 114.

A preferred embodiment comprises a computer (PC) driven multistep process. In a first step, before the FOUP 150 arrives to the load port 102 (LP), the AMC real-time monitor 120 (measuring device) is purged with ultra-pure gases 104; such gases can, e.g., be N2/CDA (Nitrogen, Clean Dry Air) to ensure low background and readiness to conduct actual FOUP measurements. Valves 111 and 112 are closed and valves 113 and 114 are opened. Purging is to be conducted, e.g. for 2 to 3 min or until a pre-determined level is reached.

In a second step, the FOUP 150 arrives to the LP 102 for AMC inspection after cleaning. Valves 111, 113 and 114 are closed and valve 112 is opened. A monitor, e.g. measuring AMC real-time monitor 120, will show if the level of AMC is meeting pre-determined requirements, i.e., the contamination is measured and a measurement result 122 can be provided. AMC leaves the FOUP 150 via line 108 at the load port 102. In this way, a fluid connection of the AMC real-time monitor 120 to an inside of the FOUP 150 is established.

In a third step, the FOUP 150 may be additionally purged with ultra-pure gases if required, this is, e.g. the case when the FOUP is inspected after cleaning. Valves 111, 112 and 114 are opened and valve 113 is closed. Such ultra-pure gases enter the FOUP 150 via line 106 at the load port 102 and leaves the FOUP 150 via line 108.

Fig. 2 illustrates, in a diagram, an example of a CRDS (cavity ring down spectroscopy) tool application to establish M800 cleaning efficiency of FOUPs intentionally contaminated with ammonia at approx. 1000 ppb for various times, 10 min (or 10 to 15 min, measurement 1), 1 h (measurement 2), 5 hrs (measurement 3), 24 hrs (measurement 4) (horizontal axis showing corresponding measurements), and a corresponding cleaning efficiency (based on a ratio between before and immediately after cleaning) achieved utilizing standard cleaning processes. The vertical axis shows an ammonia concentration c inside the FOUP in pbb.

At each of the four times, the left column indicates the ammonia concentration before cleaning, and the right column indicates the ammonia concentration after cleaning. The cleaning efficiency ranges from 99.7% at the first shown time (10 to 15 min) to 92% at the fourth show time (24 hrs).

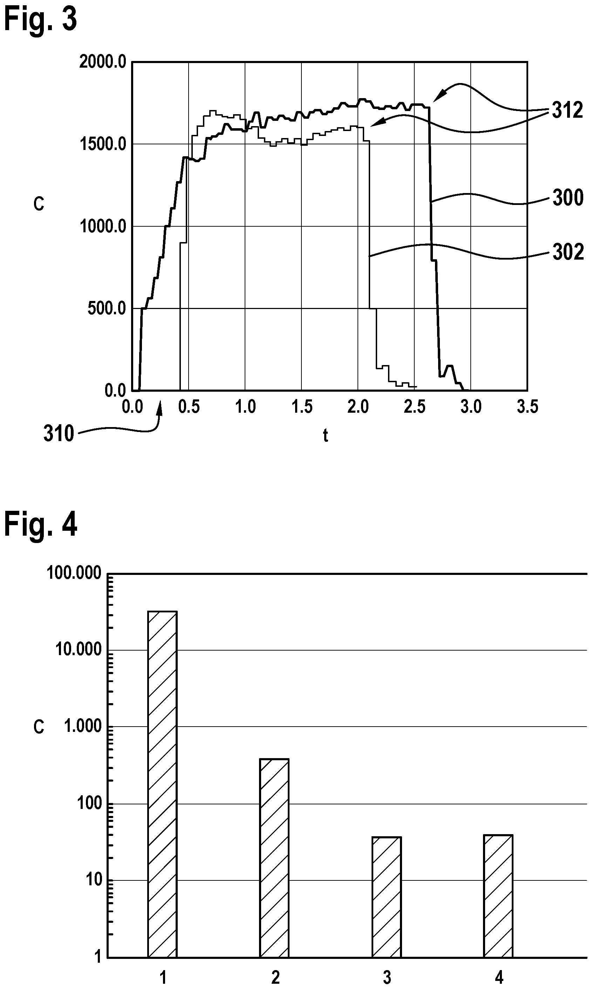

Fig. 3 illustrates, in a diagram, a measuring process flow according to a preferred embodiment (first and second step mentioned above with respect to Fig. 1). The diagram shows, on the horizontal axis, a measurement time t in min., and on the vertical axis a concentration c inside the FOUP in pbb. FOUPs are intentionally contaminated with model VOCs (acetic acid or PGMEA, Propylene Glycol Methyl Ether Acetate - see the two different lines 300 (acetic acid), 302 (PGMEA) in the diagram) placed on the LP. At the beginning, see 310, the FOUP is placed on the LP. The FOUP is measured - it takes approx. 60 to 90 sec to establish a reasonably stable reading of approx. 1500 to 1600 ppb - and finally the FOUP is removed, see 312, from the LP after completion of the measurements. The measurement time is, for example, 1.5 to 2 min. The VOC monitor is, after removal of the FOUP at 312, zeroed by exposing it to clean room environment or by purging all corresponding plumbing with N2 or clean dry air (CDA).

Fig. 4 illustrates, in a diagram, an example of an FID (flame ionization detection of total, non-methane, VOC presence) tool application to show the cleaning progress of a production FOUP with a very high contamination level. This is an example for the case when "before cleaning" measurements may trigger the application of special cleaning recipes; the FOUP can be also inspected "after cleaning".

The diagram shows, on the horizontal axis, a measurement number, and on the vertical axis VOCs (concentration c) total inside the FOUP in pbb. Measurement 1 is for the FOUP as received, measurement 2 is after a first cleaning step, measurement 3 is after a second cleaning step, and measurement 4 is after a third cleaning step. Cleaning efficiency at the first cleaning step is about 98% (i.e., the concentration ratio between measurements 2 and 1, is about 2%), and the cleaning efficiency at the second cleaning step is about 92% (i.e., the concentration ratio between measurements 3 and 2 is about 8 %).

This shows that a cleaning efficiency (with a particular customized cleaning recipe) of more than 90%, more than 95% or even at least 98% can be achieved, in particular with a first cleaning step. The FOUP may then only be provided for further use if such cleaning efficiency has been as discussed (a corresponding further measurement can be done for determining this). In further cleaning step, an additional cleaning efficiency of more than 80%, more than 90% or even at least 982 can be achieved. The FOUP may then only be provided for further use if such cleaning efficiency with the second step (e.g., in addition to the first step) has been as discussed (a corresponding further measurement can be done for determining this).

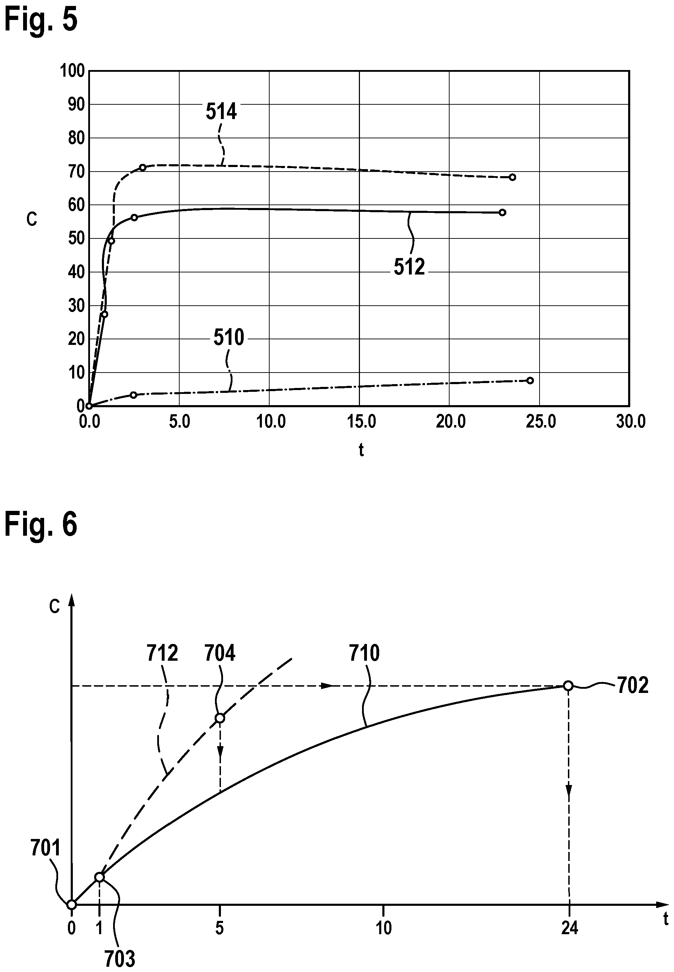

Fig. 5 illustrates, in a diagram, an example of an CRDS (cavity ring down spectroscopy) tool application to establish post-clean residual outgas as a function of the FOUP contamination level with PGMEA (model compound). The diagram shows, on the horizontal axis, a post-clean time (t) in hrs., and on the vertical axis PGMEA (concentration c) inside the FOUP in pbb.

At t=0, immediately after the cleaning, e.g. M800 standard cleaning, a PGMEA level was not detected but in time (for instance 2 to 24 hrs later), residual PGMEA started to out-gas reaching approx. 60 to 70 ppb after 24 hrs (for high initial contamination level (initial exposure) of approx. 2500 ppb for 24 hrs, see lines 512, 514) and barely measurable approx. 5 ppb for low initial contamination level (initial exposure) of approx. 370 ppb for 24 hrs, see line 510.

The diagrams in Figs. 2 to 5 clearly show that despite cleaning procedures, contamination, in particular AMC, can be present. Thus, integrating contamination or AMC measuring into a handling apparatus allows improving cleanliness of the semiconductor carrier device.

Fig. 6 illustrates, in a diagram, a method for measuring a contamination of a semiconductor carrier device in another embodiment. This embodiment relates to the heating of the semiconductor carrier device. However, it can also be used in combination with the embodiment relating to the integration of contamination measuring of a semiconductor carrier device into a handling apparatus, as described with respect to Fig. 1.

The diagram shows, on the horizontal axis, an approx. time t after cleaning, in hrs., and on the vertical axis a concentration c of AMC inside the FOUP.

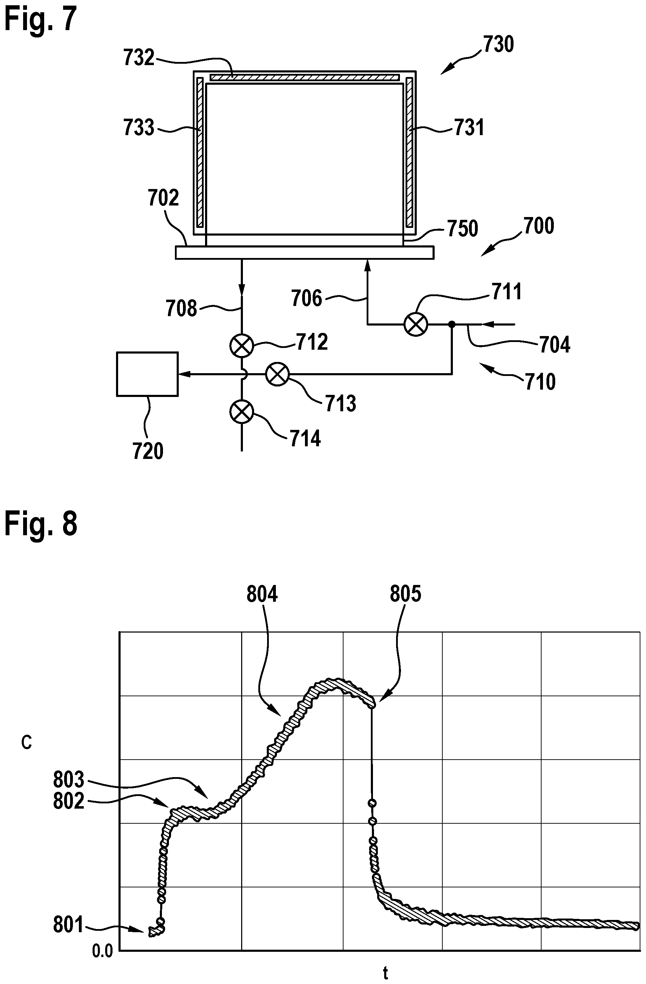

Fig. 7 illustrates a system 700 for measuring a contamination of a semiconductor carrier device 750, e.g. a FOUP, for the embodiment according to Fig. 6.

It is well known that the FOUP overall contamination level depends on the exposure dose (concentration times time) which is difficult to predict and control in high volume semiconductor devices manufacturing. Practical examples (see Figs. 4 and 5) show that in some cases multiple cleaning cycles may be required to reach a set level (Fig. 4) or that a FOUP may have post-clean residual outgassing 10 to 24 hrs later even though the AMC device shows an undetectable level of contaminant immediately after cleaning (see Fig. 5).

Post-clean outgassing is caused by contaminants residing in the depth of the polymeric material the FOUP is made of. The outgassing process which is driven by bulk diffusion is slow at room temperature but significantly accelerated at high temperature.

The diagram in Fig. 6 is explaining the embodiment making use of that. At time zero (immediately after FOUP clean) the AMC measuring device is not detecting contaminants or detecting contaminants at very low level (see point 701 in Fig. 6), after 10 hrs the contamination level is getting closer to the required limit and at 24 hrs (see point 702 in Fig. 6 while FOUP is kept at room temperature, solid line 710) this limit is reached and the FOUP can no longer be used without additional de-contamination.

To avoid this time delay and potential damage of the substrates placed in such mini-environment, the discussed embodiment provides accelerated FOUP AMC inspection (or just contamination measurement) by using heating and, thus, thermo-induced desorption of residual contaminants, and direct sampling of the internal FOUP volume with AMC measuring device to detect and quantify harmful contaminants.

In one example case (see point 703 in Fig. 6) the rate (e.g. in common units ppb/min or other) of post-clean outgassing may be established after 1 to 2 hrs after FOUP cleaning. In another example case the post-clean outgassing may be established after 5 hrs (flash heating of the FOUP), when the FOUP is heated to approx. 70°C, dashed line 712.

Thus, an obtained value at high temperature (see point 704 in Fig. 6) is a "snap-shot" of a residual outgassing at room temperature and allows to predict and/or project the outgassing behaviour without significant wait time.

Thermo-induced desorption of residual contaminants can be achieved by placing the FOUP on the load port fitted with a furnace or other heating means; in particular, the furnace or heating means should be capable to provide ballistic heating (for, e.g., 1 to 2 min) of the mini-environment with the aid of, e.g., IR lamps or resistive elements (shown as rectangles at the outside of FOUP walls, in Fig. 7). Such heating preferably ensures uniform power density distribution and does not exceed a temperature level to cause any structural damages of the FOUP materials. The system 700 shown in Fig. 7 comprises a load port 702, a furnace 730 and an AMC detection device 720 (measuring device) with appropriate plumbing and valving, see valving system 710; the system can be an integral part of a FOUP cleaning machine (as described with respect to the embodiment of Fig. 1) or it can be a stand-alone system.

It is noted that the system of Fig. 7 by means of example corresponds to the system of Fig. 1, with the additional furnace 730 for heating the FOUP 750 (reference numerals correspond to each other, with a leading 7 instead of a leading 1). By means of example, furnace 730 comprises three IR lamps or resistive elements 731, 732, 733, arranged such that they will be placed opposite to different outer surfaces of the FOUP).

A preferred embodiment comprises a computer (PC) driven multistep processes. In a first step, before the FOUP 750 arrives to the load port (LP), the AMC real-time monitor 720 (measuring device) is purged with ultra-pure gases 704, e.g., N2/CDA to ensure low background and readiness to conduct the actual FOUP measurements. Valves 711 and 712 are closed and valves 713 and 714 are opened. The purging can, for example, be conducted for 2 to 3 min or until reach-predetermined level is reached.

In a second step, the FOUP 750 arrives to the LP 702 for AMC inspection. The furnace 730 is placed on the FOUP 750 and the FOUP is heated, e.g. to a pre-determined temperature. a suitable pre-determined temperature is, for example, a maximum allowable temperature which does not cause structural changes in FOUP materials. Different FOUP materials will have different maximum temperatures. It has been shown that a certain kind of FOUP can be exposed to 80°C continuously, another kind of FOUP can be exposed to temperatures even higher than 100°C. A glass-transition temperature (beginning of structural changes) can be used as a maximum temperature that should not be reached, i.e. the pre-determined temperature is preferably below that value.

Valves 711, 713 and 714 are closed and valve 712 is opened. The AMC monitor, e.g. measuring AMC real-time monitor 720, with integrated pump draws a gas sample directly from the FOUP to establish if an AMC spike is meeting pre-determined requirements. AMC leaves the FOUP 750 via line 708 at the load port 702. In this way, a fluid connection of the AMC real-time monitor 720 to an inside of the FOUP 750 is established.

End users typically develop their own criteria as to such pre-determined requirements. These criteria typically will also depend on the type of AMC detected. For instance, FOUP thermo-desorption ("degassing accelerated at high temperature") will show presence of 10 ppb of ammonia, 4.5 ppb of HF (hydrogen fluoride) and 67 ppb of PGMEA. All parameters may be OK (i.e. the respective concentrations are within a suitable range or above or below a certain threshold), one parameter may be OK and so on. If at least one parameter is outside of a pre-determined range or above or below a certain threshold , then the FOUP cleaning may be determined to be repeated.

Fig. 8 illustrates, in a diagram, an example of the application of thermo-induced desorption of residual contaminations from the FOUP materials. The diagram shows, on the horizontal axis, a time t, and on the vertical axis an ammonia concentration c in Spectra FOUP in pbb. In step 801, the FOUP is placed on a load port fitted with an AMC monitor fluidly connected with the internal FOUP volume. In step 802, the AMC monitor is responding on presence of ammonia (a selected contaminant for the example). In step 803, the FOUP heating started and reached a pre-determined level. In step 804, the heating is terminated. In step 805, the FOUP is removed from the load port and the AMC monitor is zeroed.

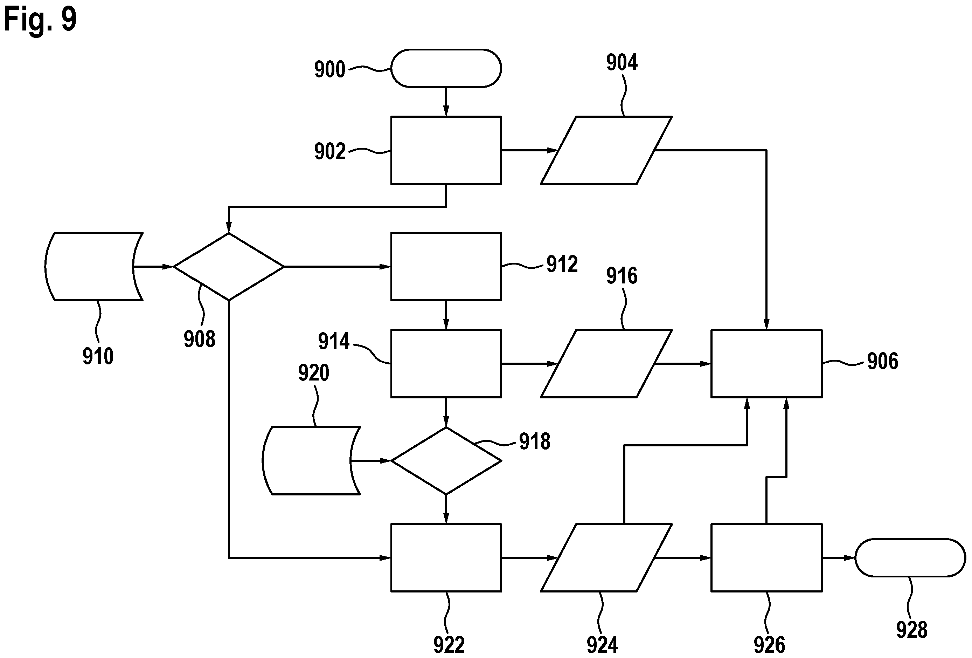

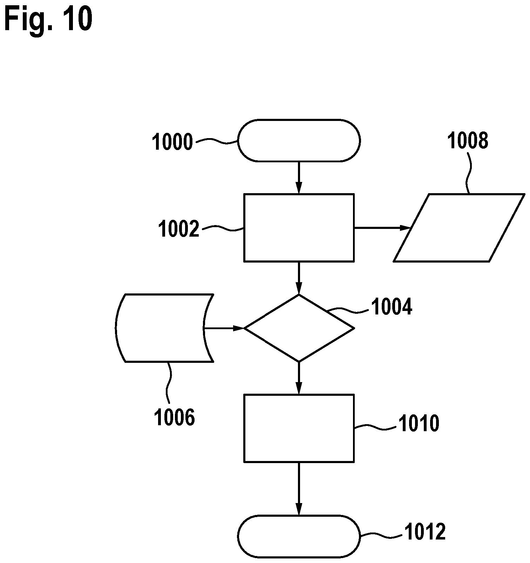

Figs. 9 and 10 illustrate, in flow diagrams, an example of the application of AMC metrology integrated into a wafer sorting tool or like apparatus. The respective embodiment relates to the integration of contamination measuring of a semiconductor carrier device into a semiconductor or wafer sorting apparatus. This allows point-of-use inspection of FOUPs with wafers during a wafer sorting process and rapid reaction on any excursions.

A FOUP with production wafers arrives to the water sorting tool, step 900 (start), and is inspected at step 702 (measure FOUP with wafers after process). Collected data 904 (initial AMC level) are, optionally, communicated to a FOUP cleaner 906. Data 904 (initial AMC level) is compared, at step 908, to a specification 910 (AMC level allowed for FOUP with processed wafer) in order to make a decision about the FOUP with loaded wafers (i.e. in a loaded situation). If it meets the specification 910 (contamination below a first pre-defined threshold, not "too dirty"), then the wafers are unloaded at step 910 and the given FOUP is inspected again at step 914 (i.e. in an unloaded situation, unloaded FOUP is measured) and obtained data 916 (empty FOUP AMC data) are, optionally, compared with data 904, and communicated to the FOUP cleaner 906 to select an appropriate cleaning recipe (e.g., for subsequent cleaning of the FOUP).

Data 916 is compared, at step 918, to a specification 920 (AMC level allowed for empty FOUP). If the empty FOUP is too dirty (contamination above a second pre-defined threshold), then after an additional diagnostics at step 922 (diagnostic measurement), data analysis (i.e. analysis of data obtained in the diagnostics) is done at step 924 and, optionally, communicated with the cleaner 906. Further, the FOUP is rejected at step 926 (FOUP AMC excursion alarm), e.g., for further action. The data 904, 916, 924 (or part of it) can then be communicated to the cleaner 906; this can be done if the respective data was not communicated as described above with optional steps. The described process ends here, 928. However, a further cleaning process can follow.

If the FOUP with wafers is not passing the specification 910 at step 908 (contamination above the first pre-defined threshold), then diagnostics at step 922, data analysis at step 924 and rejection at step 926 (same steps as above) allow to reject the FOUP for further action.

As illustrated in Fig. 10, in parallel with or in addition to the above (as shown in Fig. 9), a wafer sorting tool or like apparatus with an integrated metrology system (as described in the previous embodiments, for example) can be run that allows to inspect the FOUP arrived to an available load port, e.g., from 922 or 926 and, e.g., after an additional action like specific cleaning (which can take place after step 926 as mentioned above).

The FOUP arrives, step 1000 (start). The FOUP is empty and, in particular cleaned. A contamination measurement is done at step 1002 and it is compared, step 1004, to the specification 1006 (allowed AMC level or threshold for empty FOUP, in particular clean empty FOUP). If data 1008 collected at step 1002 is matching the specification 1006 (i.e., the contamination is below the allowed AMC level), wafer loading is authorized at step 1010. The described process ends here, 1012.

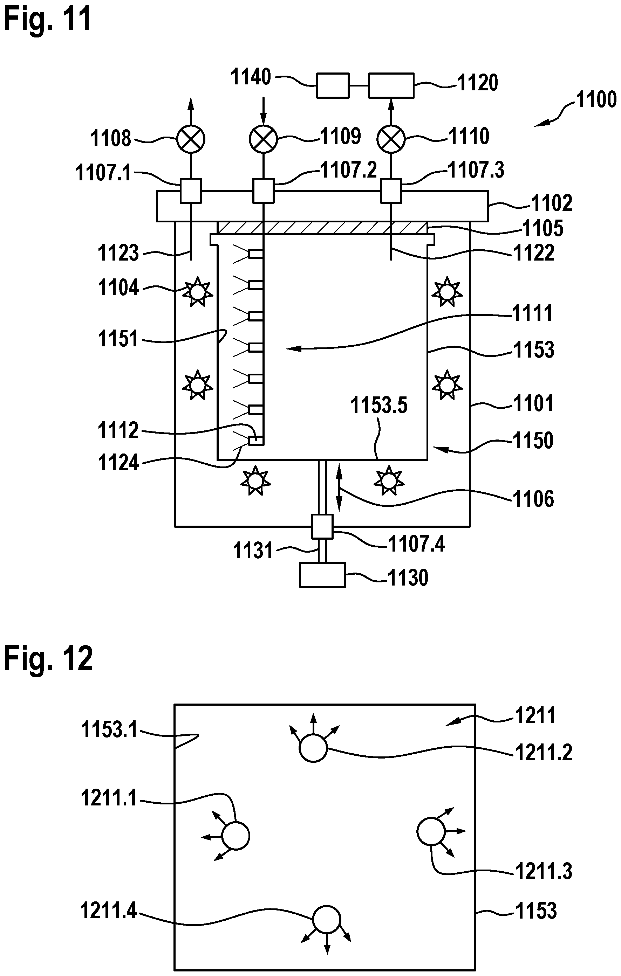

Fig. 11 illustrates a system 1100 for measuring a contamination of a semiconductor carrier device 1150, e.g. a FOUP, in another embodiment. This embodiment relates to using a vacuum chamber associated with the load port and also relates to heating the semiconductor carrier device. This embodiment also relates to the embodiment shown in Figs. 6 and 7 and provides other and/or additional features. This embodiment also uses a system similar to the system shown in Fig. 1.

Semiconductor substrates contamination with particulates during various processing steps has always been a problem in semiconductors manufacturing. Residual particulates are coming from multiple source in the fab including placement and removal of wafers to and from the FOUP, FOUP contamination caused by interfacing with processing tools and etc.

Industry is setting very tight limits on presence of particulates in wafer carriers therefore cleaning efficiency of FOUPs and inspection after the cleaning is of high importance for reduction of yield losses.

The embodiment illustrated in Fig. 11 also relates to integration of particles metrology systems and methods into FOUP cleaning machine or FOUP optical inspection tool to enable total quality control solution. Integrated metrology can help reduce metrology cost for high
volume semiconductor devices manufacturing and enable rapid reaction on occurrence of contamination events.

In particular, the embodiment relates to a method of detecting airborne particulates in a wafer pod (FOUP) after pod cleaning process has been realized on a pod cleaning tool. In particular, the wafer pod cleaning tool may comprise several cleaning steps such as washing and/or drying, followed by additional degassing in a vacuum chamber and purging with ultrapure gas such as N2 or CDA. In another example, the wafer pod cleaning tool may have integrated an optical inspection station (IS) to determine the presence of foreign objects, gasket misalignment, missing and/or misplaced parts inside, condition of purge ports and gas conductance indicating likelihood of a leak. In another example it is proposed to integrate airborne particulates detection system (measuring device) and methods within a vacuum chamber or within the IS to realize dual usage of available hardware.

An exemplary description of a system 1100 for measuring contamination of a semiconductor carrier device according to this embodiment, in particular with respect to the vacuum chamber, is given in the following (see Fig. 11).

There is provided a vacuum chamber 1101 with sufficient volume to accommodate a mini environment 1150 (e.g., a FOUP), which commonly comprises a shell 1153 and a and removable lid. The shell 1153 is separated from the lid e.g. manually or with the aid of robotic equipment and placed in a "shell holder" within the vacuum chamber 1101. The lid is placed separately from the shell 1153 in a "lid holder" (it is not shown in Fig. 11).

A vacuum chamber flange 1102 with a proper vacuum seal provides leak-free space in which an external vacuum pump (not shown) with additional feed through(s) 1107.1 and valve 1108 can reduce the chamber pressure preferably below 15 Pa, for example. At least one IR lamp 1104 (only one out of several IR lamps is assigned a reference numeral) is placed inside or outside of the shell 1153 but to ensure fast and uniform heating multiple IR lamps will be beneficial for accelerated degassing.

Upon completion of degassing to the pre-determined level (better less than 10 Pa) the vacuum chamber should be vented with ultra pure, particle free gas, like N2 or CDA. A gas conduit 1122 introduced via feed though 1107.3 and valve 1110 allows gas stream into the chamber and vented gas leaving the chamber via gas conduit towards measuring device 1120, e.g. an ADPC. Alternatively, or additionally, A gas conduit introduced via feed though 1107.1 and valve 1108 allows gas stream into the chamber and vented gas leaving the chamber via gas conduit 1123 towards measuring device 1120; note that gas conduit 1122 is inserted into the pod 1150 with shell 1153, gas conduit 1123 only into the vacuum chamber outside of the shell 1153.

In an embodiment, the bottom of the vacuum chamber is equipped with a mechanism 1130 (moving system) of gentle upward and/or downward movement 1106of the shell holder 1131 assisted with common vacuum feedthrough 1107.4. Upward movement of the shell holder 1131 with the shell 1153 allows to create a "confined space" with the docking plate 1105 and enables more accurate measurement of residual particulates displaced by gas jets. Such docking plate 1105 can, e.g., in combination with vacuum chamber flange 1102, form a load port or be part of such load port.

In an embodiment, wafer pod residual particulates inspection is performed with the aid of a gas conduit 1111 which has a set of appropriately spaced nozzles (spraying system comprising one or multiple nozzles, one such nozzle referred to as 1112) facing, e.g., a given side (e.g., side 1153.3) of the shell 1153 (at its inside) at appropriate angle (for example, 90 degrees or less than 90 degrees, e.g. between 45 and 90 degrees) to provide good surface coverage and powerful gas impulse (see gas 1124 leaving the nozzle) to dislocate residual particulates from the pod walls. The shown gas conduit 1111 also may be extended to cover the bottom 1153.5 of the carrier (as placed in Fig. 11).

Detached particulates are carried away by the external vacuum pump of a measuring device 1120, e.g. an Air Born Dry Particle Counter (ADPC), via a feed through 1107.3 and a valve 1110). It is beneficial to have four gas conduits facing each side (side walls like shown side 1153.1) of the mini environment (the spraying system 1211 comprising then multiple conduits, each having one or multiple nozzles, see top view in Fig. 12, with also shell 1153 in top view). In such case, valve 1109 is a multipath valve successively introducing a gas stream to the selected mini environment side to enable measurements of residual particulates (conduits 1211.1 or 1211.2 or 1211.3 or 1211.4 in Fig. 12) with the aid of ADPC fluidly connected with a "confined space" which consists of the mini environment's shell and docking plate.

A variety of ADPCs are available. Optical particle counters (OPC), for example, employ a
small sensing volume in which particles are detected by reflecting light of focused incandescent lamp or by laser source.

Generally, commercial instruments capable to measure up to 10e6 (one million) particles / liter with the smallest size detected in the vicinity of approx. 0.1 µm. A condensation particle counters (CPC), for example, is based on counting of aerosol particles formed in a supersaturated gas stream. A CPC, generally, is capable to detect particulates in the range of 10 nm to 1000 nm.

After completion of the mini environment inspection, the mechanism 1130 (see also movement 1106, Fig. 11) moves the mini-environment shell holder 1131 downward, the vacuum chamber is opened, the mini environment is assembled (i.e. the lid is placed on the shell) and then removed from the vacuum chamber with the aid of, e.g. robotic equipment.

The system can also comprise a computerized system 1140 linked to the ADPC 1120 which will enable a specific cleaning protocol of a given mini environment if pre-determined particle counts are not attained. For example, side 1153.1 (see side of conduit 1211.1 in Fig. 12) is showing high counts (particles/liter) thus this mini environment cannot be returned to the production. This finding can trigger the action, i.e. the pod is removed from the vacuum chamber and delivered back to the washing or cleaning chamber of a pod cleaning tool. The cleaning recipe in the washing chamber can be selected to specifically focus on washing side 1153.1 which failed during inspection.

Figs. 13 and 14 illustrate a system 1300 for measuring a contamination of a semiconductor carrier device 1350 in another embodiment. This embodiment relates to optically inspecting an inside of the semiconductor carrier device, using a vacuum chamber 1301 associated with load port. This embodiment also relates to heating the semiconductor carrier device before measuring the contamination. This embodiment also relates to the embodiment shown in Figs. 11 and 12 and provides other and/or additional features compared to the embodiment shown in Figs. 11 and 12.

In particular, this embodiment provides a method of particulates measurement in a wafer carrier which can be conducted in an inspection station 1301 (see Fig. 13) also capable to optically inspect the wafer carrier (e.g., FOUP) before cleaning.

In an embodiment, a robotic arm holds the wafer carrier (with the lid removed beforehand) by an automation handle 1305 and transferring the carrier 1350 into the inspection station 1370 having a vacuum chamber 1301 and which is, for example, fitted with chemical and particle filters 1302 to create a clean environment inside station 1370 or its vacuum chamber 1301, respectively.

Firstly, a carrier interior optical inspection can be conducted with the aid of camera 1304, secondly the wafer carrier can be rotated by, e.g. 180 degree (see Fig. 14), and optical inspection of the exterior carrier back can then be conducted (also by means of the camera), and then a robotic arm can move the carrier toward (see movement direction 1306) a system 1300 (particle measuring system, including a measuring device 1320, e.g. an ADPC) which includes a docking plate 1307 (forming or acting as load port, for example) to form a "confined space" with the shell 1153 of the carrier 1350, gas conduits 1311 (at least one) with appropriately spaced nozzles 1308. See also Fig. 11 for a more detailed description, for example.

Two conduits are shown, but four conduits facing each shell side (like shown in Fig. 12) can provide an option to sequentially measure particulates displaced by powerful gas impulse enabling selection of an appropriate cleaning protocol or recipe. A multiport valve 1309 can provide distribution of the gas flow (e.g., purge gas) to the appropriate gas conduit and an external pump of ADPC 1320 synchronized with this gas impulse can draw a sample for measurements.

Major advantages of the disclosed embodiments are the dual use of a vacuum chamber for cleaning followed by inspection within a FOUP cleaning tool, a dual use of a test chamber for both cleaning and inspection and the way purge gas is introduced, and a dual use of a vacuum chamber within an existing FOUP cleaning tool, high customization level and cost reduction. The disclosed embodiments can also utilize different FOUP positions (vertical, opening up).

## Claims

1. Method for measuring a contamination of a semiconductor carrier device (150, 750, 1150, 1350), using a measuring device (120, 720, 1120, 1320) connected to a load port (102, 702, 1307) for the semiconductor carrier device (150), the method comprising:
after the semiconductor carrier device (150) has arrived in or at the load port (102): establishing a fluid connection of the measuring device (120), to an inside of the semiconductor carrier device (150) and measuring the contamination of the semiconductor carrier device; and
providing a measurement result (122).

2. The method according to claim 1, further comprising:
determining, based on the measurement result (122), a customized cleaning recipe for the semiconductor carrier device (150, 750, 1150, 1350).

3. The method according to claim 2, wherein, if the measurement result indicates a contamination of the semiconductor carrier device (150, 750, 1150, 1350) is below a pre-defined threshold, the customized cleaning recipe comprises a light cleaning recipe, and
wherein, if the measurement result indicates a contamination of the semiconductor carrier device is above the pre-defined threshold, the customized cleaning recipe comprises a hard cleaning recipe, wherein the hard cleaning recipe comprises at least one of the following parameters with respect to the light cleaning recipe: a longer cleaning time, a higher temperature of dry gas, a higher water pressure, using de-gassing step, using IR-lamp.

4. The method according to claim 2 or 3, further comprising:
cleaning the semiconductor carrier device according to the determined customized cleaning recipe; and
providing the carrier device for further use only if a cleaning efficiency with the customized cleaning recipe has been more than 90%, in particular more than 95%.

5. The method according to any one of the preceding claims, wherein the measuring device is integrated into a semiconductor carrier device handling apparatus, which apparatus comprises the load port (1307).

6. The method according to claim 5, wherein the semiconductor carrier device handling apparatus is an optical inspection station (1370) or an overhead transportation station.

7. The method according to any one of the preceding claims, further comprising:
before the semiconductor carrier device (150, 750, 1150, 1350) has arrived in or at the load port: cleaning the measuring device.

8. The method according to any one of the preceding claims, further comprising:
heating, at least partly during measuring the contamination of the semiconductor carrier device, the semiconductor carrier device (150, 750, 1150, 1350); and
determining, based on the measurement result, a contamination level of the semiconductor carrier device that will be reached.

9. The method according to claim 6, further using a vacuum chamber (1101, 1301) associated with the load port (1102, 1105, 1307), wherein the semiconductor carrier device is to be placed in the vacuum chamber.

10. The method according to claim 9, wherein the semiconductor carrier device is heated by means of one or multiple IR lamps (1104) arranged inside the vacuum chamber (1101), and/or
wherein an inside of the semiconductor carrier device is confined in that the semiconductor carrier device is moved towards a docking plate (1102) of the vacuum chamber by means of a moving system (1130, 1131) arranged at least partly inside the vacuum chamber.

11. The method according to any one of claims 9 to 10, further comprising:
providing a spraying system (1211) comprising one or multiple nozzles (1112, 1211.1, 1211.2, 1211.3, 1211.4) inside the semiconductor carrier device, and
spraying gas via the one or multiple nozzles onto one or multiple walls of the semiconductor carrier device for dislocation contamination for the measuring.

12. The method according to any one of claims 9 to 11, further comprising:
before measuring the contamination of the semiconductor carrier device, optically inspecting an inside of the semiconductor carrier device, by means of a camera (1304) arranged inside the vacuum chamber (1301).

13. The method according to any one of the preceding claims, wherein the measuring device (120, 720) is integrated into a semiconductor or wafer sorting apparatus, which apparatus comprises the load port,
wherein contamination of the semiconductor carrier device is measured for at least one of the following situations:
- a loaded situation, with the semiconductor or wafer having been processed and being placed in the semiconductor carrier device;
- an unloaded situation, with the semiconductor or wafer having been removed from the semiconductor carrier device.

14. The method according to claim 13, further comprising:
- for the loaded situation, if the measurement result indicates a contamination of the semiconductor carrier device is above a first pre-defined threshold, performing a diagnostic measurement; and
- for the unloaded situation, if the measurement result indicates a contamination of the semiconductor carrier device is above a second pre-defined threshold, performing a diagnostic measurement.

15. The method according to claim 14, further comprising: determining a cleaning recipe for the semiconductor carrier device, based on a result of the diagnostic measurement.

16. The method according to any one of the preceding claims, wherein the contamination is AMC and the measuring device (120, 720, 1120, 1320) is an AMC metrology,
especially, wherein the measuring device (120, 720, 1120, 1320) is configured to detect and/or measure contamination level of one or more pre-defined AMC types or components, e.g., ammonia, total bases, acids, organics, residual humidity, and/or
wherein the measuring device (120, 720, 1120, 1320) is based on at least one of: ion-mobility spectrometry, cavity ring down spectroscopy, UV fluorescence, proton transfer reaction - quad mass spectrometry, flame ionization detection.

17. A system (100, 700, 1100, 1300) for measuring a contamination of a semiconductor carrier device (150, 750, 1150, 1350), comprising a load port (102, 702, 1307) for the semiconductor carrier device and a measuring device (120, 720, 1120, 1320) connected to the load port (102, 702, 1307), the system configured to:
after the semiconductor carrier device (150, 750, 1150, 1350) has arrived in or at the load port (102, 702, 1307), establish a fluid connection of the measuring device (120, 720, 1120, 1320), to an inside of the semiconductor carrier device (150, 750, 1150, 1350) and measuring the contamination of the semiconductor carrier device; and
provide a measurement result (122).

18. The system (100, 700, 1100, 1300) according to claim 17, implementing the method of any one of claims 1 to 16.
